Europäisches Patentamt

European Patent Office

Office européen des brevets

(19)

(11) **EP 0 670 629 B1**

(12)

# FASCICULE DE BREVET EUROPEEN

(45) Date de publication et mention
de la délivrance du brevet:
**07.07.1999 Bulletin 1999/27**

(51) Int Cl.[6]: **H03D 13/00**, H03L 7/089

(21) Numéro de dépôt: **95200382.0**

(22) Date de dépôt: **17.02.1995**

(54) **Dispositif oscillateur verrouillé en phase**

Phasenregelkreis

Phase locked loop

(84) Etats contractants désignés:
**DE FR GB**

(30) Priorité: **02.03.1994 FR 9402383**

(43) Date de publication de la demande:
**06.09.1995 Bulletin 1995/36**

(73) Titulaires:
- **PHILIPS COMPOSANTS ET
  SEMICONDUCTEURS
  92150 Suresnes (FR)**
  Etats contractants désignés:
  **FR**
- **Koninklijke Philips Electronics N.V.
  5621 BA Eindhoven (NL)**
  Etats contractants désignés:
  **DE GB**

(72) Inventeur: **Dufour, Yves, Société Civile S.P.I.D.
F-75008 Paris (FR)**

(74) Mandataire: **Charpail, François et al
Société Civile S.P.I.D.
156, Boulevard Haussmann
75008 Paris (FR)**

(56) Documents cités:
**WO-A-91/00649          DE-A- 3 813 550
US-A- 4 970 475**

## Description

La présente invention concerne un dispositif oscillateur verrouillé en phase dans lequel un oscillateur à fréquence variable délivre un signal de sortie contrôlé par une tension de commande issue d'une capacité réservoir chargée par un circuit pompe de charge, dispositif comportant un détecteur de phase dont une entrée reçoit un signal dérivé du signal de sortie de l'oscillateur à fréquence variable, une autre entrée reçoit un signal d'un oscillateur de référence, et qui possède également une entrée de remise à zéro,
le circuit pompe de charge muni de deux sources de courant chacune composée de plusieurs transistors fonctionnant en parallèle, respectivement chargeant et déchargeant la capacité réservoir, et muni de deux entrées, d'une part, une première entrée de commande couplée à une première sortie du détecteur de phase laquelle fournit un signal de commutation dit signal de commande de montée, activant l'une des sources de courant, et d'autre part, une deuxième entrée de commande couplée à une deuxième sortie du détecteur de phase laquelle fournit un autre signal de commutation dit signal de commande de descente activant l'autre source de courant, dispositif dans lequel l'intervalle de temps durant lequel ces deux signaux de commande sont actifs simultanément est contrôlé par un signal de remise à zéro signal qui est issu d'une porte logique combinant les signaux de commande de montée et de descente et est appliqué à l'entrée de remise à zéro du détecteur de phase après passage dans un dispositif de retardement.

Un dispositif de ce type est connu du document EP-A-449659.

Pour obtenir un fonctionnement linéaire du circuit pompe de charge, il est nécessaire de prévoir que les deux sources de courant respectivement, chargeant et déchargeant la capacité réservoir puissent être actives simultanément. Ainsi tout décalage temporel aussi petit qu'il soit, entre les commandes de descente et de montée appliquées aux sources de courant de la pompe de charge est susceptible de fournir une charge nette de la capacité réservoir et on évite ainsi une zone dite "zone morte" dans le contrôle de la tension aux bornes de cette capacité.

Toutefois, la durée pendant laquelle les deux sources de courant de la pompe de charge sont actives simultanément, doit être aussi réduite que possible, d'une part pour des raisons de consommation de courant, ce qui est particulièrement important lorsque l'application est d'un type portatif alimenté par des piles, et d'autre part pour des raisons de bruit, étant donné que lorsque les deux sources de courant sont inactives le bruit aux bornes de la capacité réservoir peut être considéré comme nul, alors qu'il est présent lorque les deux sources de courant sont actives, bruit qui provient à la fois desdites sources de courant et de leur signal de commande.

Ainsi le problème technique à résoudre est de contrôler à une valeur minimale l'intervalle de temps durant lequel les deux sources de courant de la pompe de charge sont actives simultanément.

D'un point de vue technologique, il apparait que les temps de réaction sont les plus longs dans la partie concernant la pompe de charge qui fait appel à des transistors largement dimensionnés, tandis que les signaux de commande peuvent être réalisés par des circuits logiques à faible consommation dont les temps de commutation sont nettement plus petits.

Ainsi, il a donc été proposé d'utiliser les commandes de montée et de descente pour détecter de manière logique, le moment où ces commandes sont actives simultanément et d'appliquer le signal résultant à un dispositif de retardement qui prend en compte le délai relativement important d'établissement du courant dans les sources de courant de la pompe de charge. Le signal issu de ce dispositif de retardement est alors appliqué sur une entrée de remise à zéro du détecteur de phase ou, ce qui revient au même, sur un dispositif logique commutant les signaux de commande de montée et de descente à leur niveau logique inactif.

Un dispositif de retardement classique est constitué d'une pluralité de portes logiques disposées en série, le retard obtenu en sortie de ce dispositif étant égal à la somme du délai de réaction de toutes les portes utilisées. Si l'on observe maintenant le comportement d'un tel système en fonction de la température, il apparaît que le délai obtenu par le dispositif de retardement peut être correctement adapté au temps de montée des sources de courant de la pompe de charge à une certaine température, alors qu'aux températures extrêmes de la plage de température spécifiée, ce délai est totalement inadapté.

Des différences de comportement en fonction de la température proviennent notamment du fait d'utiliser différentes technologies pour réaliser d'une part les portes constituant le dispositif de retardement, et d'autre part, les sources de courant de la pompe de charge.

Pour pallier cette difficulté il a été également proposé qu'un des transistors constitutif de chacune des sources de courant de la pompe de charge, soit utilisé pour générer deux signaux, qui combinés par une porte logique, fournissent en sortie le signal de remise à zéro. Selon cette technique, c'est au sein du circuit pompe de charge lui-même que se trouve effectuée la mesure du courant débité au cours du temps de sorte que cette mesure tient compte du comportement en température desdites sources de courant.

Une telle technique est donc plus précise que celle indiquée précédemment, mais présente un inconvénient, lorsque l'on cherche à faire fonctionner un tel circuit sous une tension d'alimentation réduite. En effet, on est alors amené à réserver deux transistors chacun dans l'une des sources de courant du circuit pompe de charge, exclusivement à la création du signal destiné à effectuer le retour à zéro des commandes de montée et de descente, sans que le courant débité par ces deux transistors soit utilisé pour la charge, et la décharge de la capacité réservoir.

Cette nécessité découle du fait que si le courant des transistors en question était utilisé pour charger ou décharger la capacité réservoir, on aboutirait à réduire de deux tensions de diode en direct la plage d'excursion de tension disponible sur cette capacité réservoir.

De ce fait, lorsqu'un fonctionnement à basse tension est recherché, avec une plage d'excursion en sortie du circuit à verrouillage de phase la plus étendue possible, on aboutit à ce que deux transistors, dont la surface n'est pas négligeable, soient réservés à la mesure du courant alors que le courant qu'ils débitent n'est pas utilisés pour la charge et la décharge de la capacité réservoir.

L'invention se propose de remédier aux inconvénients précités. En effet, selon l'invention, un dispositif oscillateur verrouillé en phase conforme au paragraphe introductif est caractérisé en ce que le dispositif de retardement comprend d'une part une source de courant dite annexe, qui est commutable et formée par un transistor appairé à un transistor de l'une des sources de courant du circuit pompe de charge, et d'autre part, des moyens de comparaison du courant débité par cette source de courant annexe avec un seuil de courant déterminé qui délivrent le signal de remise à zéro lorsque ce seuil est atteint.

Le dispositif selon l'invention utilise donc tout d'abord les signaux de commande de montée et de descente combinés dans une porte détectant l'état actif des deux signaux en question. Le signal résultant est alors appliqué au dispositif de retardement composé d'un transistor identique à celui de l'une des sources de courant, représentant une image du délai de mise en activité des sources de courant proprement dites du circuit pompe de charge.

Cette disposition est donc plus compacte du fait qu'elle n'utilise qu'un transistor de dimensions relativement grandes au lieu de deux. Pour obtenir un circuit pompe de charge performant, il est bien connu de rechercher un appairage aussi précis que possible du temps de montée des transistors constituant les deux sources de courant. Ainsi, l'usage d'un transistor supplémentaire de construction identique à celle de l'un des transistors de la pompe de charge, fournit une image suffisamment précise du comportement dans le temps des sources de courant de la pompe de charge. Si cependant, il y avait des raisons de penser que l'une des sources de courant de la pompe de charge soit un peu plus lente que l'autre source de courant, il y aurait lieu d'utiliser alors, en tant que source de courant annexe, un transistor du type de celui utilisé dans la source de courant la plus lente de la pompe de charge.

En pratique, il est fréquent d'utiliser une association de transistors en parallèle pour réaliser les sources de courant du circuit pompe de charge, le nombre de transistors actifs pouvant être programmable en fonction des utilisations. L'augmentation de consommation découlant de la source de courant annexe est donc une fraction pratiquement négligeable du courant consommé par l'ensemble du circuit compte tenu encore du fait que la source de courant annexe ne débite que durant un temps très court indépendant du déphasage à corriger, et qui correspond uniquement au temps de montée de cette source de courant annexe. Du fait qu'il est extérieur au circuit pompe de charge, le transistor constituant la source de courant annexe est libre des contraintes de polarisation imposées aux transistors de la pompe de charge hormis la nécessité d'un bon appairage, déjà mentionnée.

En tant que moyen de comparaison du courant débité par la source de courant annexe avec un seuil de courant déterminé, une solution simple consiste à utiliser une résistance de charge en série avec ladite source de courant annexe, la chute de tension sur cette résistance de charge procurant le signal de remise à zéro. Toutefois, cette solution n'est pas optimale eu égard aux variations de la température. Selon un mode de mise en oeuvre préféré de l'invention, lesdits moyens de comparaison comprennent un miroir de courant dont une branche d'entrée reçoit le courant de la source de courant annexe et dont une branche de sortie constituant la sortie du dispositif de retardement est connectée en série à une sortie d'un générateur de courant de référence délivrant ledit seuil de courant.

Selon ce mode de mise en oeuvre, la comparaison entre le courant débité par le générateur de courant de référence et le courant délivré par la source de courant annexe permet un choix précis de la fraction du courant de la source de courant annexe pour laquelle le signal de remise à zéro est émis.

Avantageusement, ledit miroir de courant est prévu avec un rapport de courant de sortie/courant d'entrée inférieur à 1, ce qui produit une économie de consommation, le courant débité par le générateur de courant de référence n'étant alors qu'une fraction du courant nominal de la source de courant annexe.

Avantageusement des moyens s'opposant à la saturation des transistors en série dans la branche de sortie du miroir de courant peuvent être prévus. Dans une variante de mise en oeuvre avantageuse, le générateur de courant de référence délivrant le seuil de courant ainsi que le miroir de courant sont construits à l'aide de transistors à effet de champs de type MOS.

La description qui va suivre, en regard des dessins annexés, donnée à titre non limitatif, fera bien comprendre en quoi consiste l'invention et comment elle peut être réalisée.

La figure 1 représente un schéma simplifié d'un dispositif oscillateur verrouillé en phase connu, qui utilise un détecteur de phase muni d'une entrée de remise à zéro ainsi qu'un dispositif de retardement du signal de remise à zéro,
la figure 2 représente le schéma d'un dispositif oscillateur selon l'invention,

la figure 3 représente une vue partielle d'un mode de mise en oeuvre préféré du dispositif de retardement prévu dans l'invention

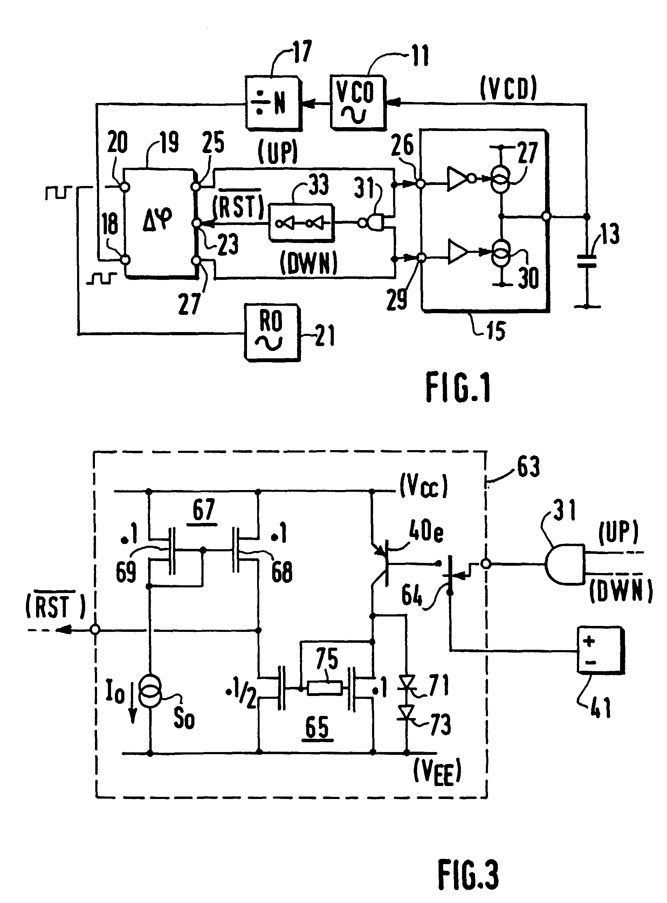

La figure 1 représente le schéma de principe général d'un dispositif oscillateur verrouillé en phase, principe qui est commun au dispositif connu et au dispositif selon l'invention.

Un oscillateur à fréquences variables 11 délivre un signal de sortie dont la fréquence est contrôlée par une tension de commande VCD issue d'une capacité réservoir 13 généralement associée à un filtre passe-bas, non représenté, cette capacité 13 étant chargée ou déchargée par un circuit pompe de charge 15. Le signal de sortie de l'oscillateur 11 subit une division de fréquence dans le diviseur 17, généralement programmable, le signal résultant de cette division est appliqué à une première entrée 18 d'un détecteur de phase 19. Une deuxième entrée 20, de ce détecteur de phase 19, reçoit le signal d'un oscillateur de référence 21. Le détecteur de phase 19 possède une entrée de remise à zéro 23 permettant de forcer à zéro l'état de deux sorties 25 et 27 de ce détecteur de phase de manière indépendante des signaux d'entrée. La sortie 25 présente un signal de sortie dit de montée UP, tandis que la sortie 27 produit un signal de descente DWN qui sont respectivement synchrones des fronts de montée des signaux d'entrée appliqués sur les entrées 18 et 20.

Les signaux de montée UP et de descente DWN sont appliqués en tant que signaux de commande aux entrées respectives 26 et 29 du circuit pompe de charge 15 pour l'activation respectivement d'une source de courant de charge 27 et d'une source de courant de décharge 30. Ces courants sont appliqués à la capacité réservoir 13. Les sources de courant 27 et 30 du circuit pompe de charge 15 sont donc activées à des instants dont l'écart dans le temps est représentatif de l'écart de phase entre les signaux comparés par le détecteur de phase 19, tandis que ces mêmes sources de courant sont désactivées par un retour à l'état inactif des commandes de montée et de descente sous l'effet du signal de remise à zéro $\overline{RST}$ appliqué au détecteur de phase 19.

Pour produire le signal de remise à zéro $\overline{RST}$, les signaux de montée UP et de descente DWN sont appliqués à l'entrée d'une porte NON-ET 31 dont le signal de sortie est retardé dans un dispositif de retardement 33. Il va de soi que le type logique de la porte 31 dépend de l'état considéré comme actif des signaux de montée UP, de descente DWN, du signal de remise à zéro $\overline{RST}$, et de l'effet inverseur ou non-inverseur du dispositif de retardement 33. La porte NON-ET 31 représentée sur la figure 1 constitue donc l'un des types de portes possibles, donné purement à titre d'exemple.

On cherche de cette manière à faire en sorte que les sources de courant 27 et 30 du circuit pompe de charge 15 aient le temps d'atteindre une fraction significative de leur courant nominal avant qu'elles ne soient commandées à l'extinction.

Comme il a déjà été indiqué, la solution connue consistant à utiliser une pluralité de portes en série pour constituer le dispositif de retardement 33 n'est pas convenable car elle ne garantit pas à toute température une compensation correcte du temps de montée des sources de courant 27 et 30 du circuit pompe de charge.

Lorsque le retard apporté par le dispositif de retardement 33 est trop court par rapport au temps de montée des sources de courant 27 et 30, ces sources de courant ne peuvent pas atteindre un niveau de courant débité significatif de sorte que le circuit pompe de charge est affecté d'une zone dite "morte". Elle devient incapable de corriger des petits écarts de phase autour de la compensation nulle. Au contraire lorsque le retard apporté par le dispositif de retardement 33 devient trop important, les sources de courant 27 et 30 débitent simultanément durant un intervalle de temps exagéré, ce qui produit d'une part une consommation inutile du courant d'alimentation et d'autre part un bruit exagéré de la fréquence délivrée par l'oscillateur à fréquence variable 11, comme conséquence du bruit présent dans la tension de commande VCD.

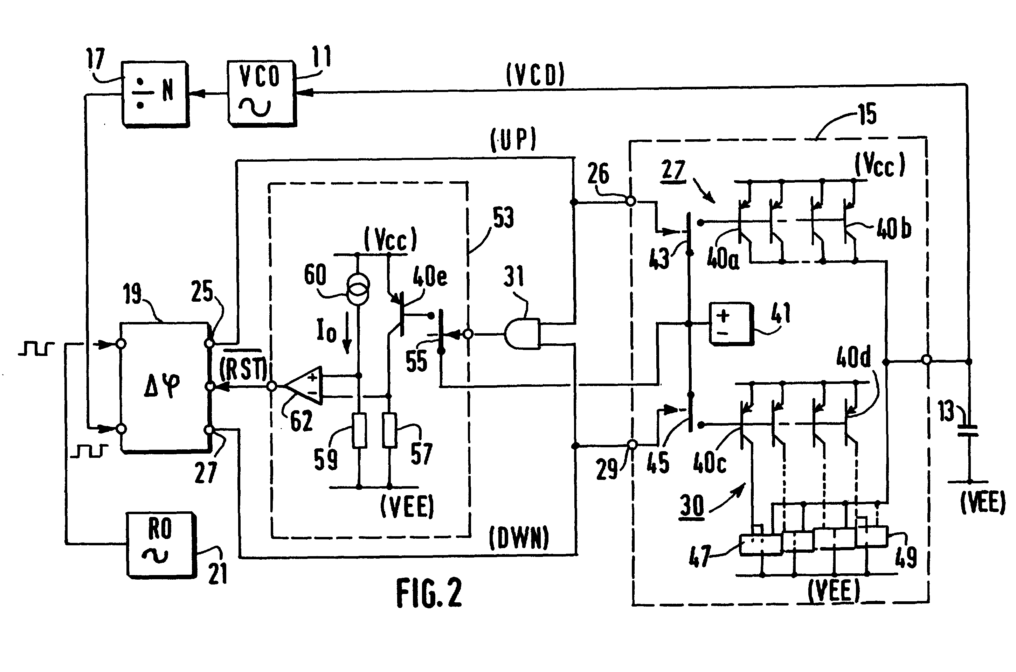

La figure 2 représente un schéma plus détaillé relatif à un dispositif oscillateur verrouillé en phase selon l'invention.

Sur cette figure, les éléments ayant mêmes fonctions que ceux de la figure 1 sont affectés des mêmes signes de références. Selon un exemple de réalisation pratique, la source de courant 27 du circuit pompe de charge 15 comporte une pluralité de transistors bipolaires de type PNP 40a-40b dont la base peut être connectée à un générateur de tensions de base 41 sous l'effet d'un interrupteur 43 commandé par le signal de commande de montée UP. Le collecteur de ces transistors fournit le courant de montée chargeant la capacité réservoir 13.

Selon une variante de réalisation non représentée sur la figure, pour plus de clarté, le nombre de transistors fonctionnant en parallèle parmi les transistors 40a-40b peut être programmable.

La source de courant 30 du circuit pompe de charge 15 est de manière semblable constituée d'une pluralité de transistors bipolaires de type PNP 40c-40d, dont la totalité ou une fraction programmable de ces transistors peut être mise en fonctionnement en parallèle sous l'effet de la commande de descente DWN actionnant un interrupteur 45 et appliquant sur les bases des transistors 40c-40d la tension fournie par le générateur de tension de base 41.

Le courant collecteur de chacun des transistors 40c-40d, est appliqué à l'entrée de miroirs de courant 47-49 formés de transistors bipolaires de type NPN, miroirs dont les sorties couplées en parallèle fournissent le courant de décharge de la capacité réservoir 13. Tous les transistors 40a-40b, 40c-40d sont de construction identique et appairés. On assure ainsi une symétrie de fonctionnement de sources de courant 27 et 30. Conformément à l'invention, un circuit de retardement 53 est constitué d'un transistor bipolaire de type PNP 40e recevant sur sa base la tension fournie par le générateur de tension de base 41 à travers un interrupteur 55 commandé par une porte ET 31 recevant en entrée les signaux de commande de montée UP et de descente DWN. Le transistor 40e est de construction identique et il est appairé à l'un quelconque des transistors 40a-40b, 40c-40d. Son comportement en commutation est donc identique à toute température à celui des transistors des sources de courant 27 et 30. Selon l'exemple représenté, le courant collecteur du transistor 40e est appliqué à une résistance de charge 57 connectée par ailleurs à une tension de référence VEE. Une source de courant de référence 60 débite en permanence un courant de référence $I_0$ qui est appliqué sur une résistance 59 connectée par ailleurs à la tension de référence VEE. Les chutes de tensions développées sur les résistances 57 et 59 sont comparées dans un comparateur 62 qui délivre en sortie le signal de remise à zéro $\overline{RST}$. On comprendra aisément, que par le choix des valeurs de résistance 57 et 59 on peut faire en sorte que le courant de référence $I_0$ soit inférieure au courant nominal du transistor 40e de sorte que la consommation présentée par ce courant de référence $I_0$ peut être suffisamment faible du point de vue de la consommation totale du circuit.

La figure 3 représente le schéma d'un dispositif de retardement 63 conforme à un mode de mise en oeuvre préféré de l'invention. Ce dispositif de retardement 63 comporte comme précédemment un transistor 40e de type PNP appairé à l'un quelconque des transistors 40a-40b, 40c-40d, des sources de courant représentées à la figure 2. Sa base reçoit un signal d'activation conditionné par l'effet d'une porte logique 31 permettant de détecter l'activation simultanée des commandes de montée UP et de descente DWN. Selon le schéma de la figure 3, la tension fournie par le générateur de tension de base 41 est utilisée pour la polarisation de la base du transistor 40e, et est appliquée à travers un interrupteur 64 commandé par la porte 31. Les moyens permettant d'évaluer au cours du temps, le courant débité par le transistor 40e formant l'image de l'un des transistors des sources de courant du circuit pompe de charge, comportent un miroir de courant 65 dont une branche d'entrée reçoit le courant collecteur du transistor 40e et dont une branche de sortie est connectée à la sortie d'un autre miroir de courant 67 référencé à la tension d'alimentation Vcc et formé de transistors MOS 68 et 69. Enfin, une source de courant So, référencée à la tension de référence VEE, débite un courant constant $I_0$ dans la branche d'entrée du miroir de courant 67. La branche de sortie du miroir de courant 65, reliée à la branche de sortie du miroir de courant 67, constitue un noeud fournissant le signal de remise à zéro $\overline{RST}$. L'ensemble formé par la source de courant So et le miroir de courant 67 constitue l'équivalent d'une source de courant de référence telle qu'indiquée en 60 à la figure 2.

Ici encore le courant $I_0$ débité par la source de courant 60 peut être une fraction seulement du courant nominal de la source de courant commutable constituée par le transistor 40e. De préférence, le miroir de courant 65 a un rapport de courant de sortie/courant d'entrée inférieur à 1, par exemple, de 1/2 ainsi qu'il est noté sur la figure. Avec un miroir de courant 67 de rapport 1/1, la valeur du courant $I_0$ fourni par la source de courant So peut être choisie par exemple à 35% du courant nominal du transistor 40e. Dans ces conditions, qui sont données purement à titre d'exemple, le signal de remise à zéro $\overline{RST}$ sera émis lorsque le courant débité par le transistor 40e aura atteint un courant égal à 70% de son courant nominal. Il est également possible d'adopter d'autres valeurs du courant $I_0$ et du rapport de courant du miroir 67 pour obtenir le même résultat.

Si le miroir de courant 67 et le miroir de courant 65 étaient réalisés à l'aide de transistors bipolaires, il y aurait intérêt à prévoir des moyens anti-saturation pour les transistors impliqués dans les branches de sortie de ces miroirs de courant.

Selon la variante de mise en oeuvre préférée, représentée à la figure 3, le miroir de courant 67 et le miroir de courant 65 sont réalisés à l'aide de transistors à effet de champs de type MOS pour lesquels les problèmes de saturation ne se posent pas. Des diodes 71 et 73 ont été connectées en parallèle, entre le collecteur du transistor bipolaire 40e et la borne de référence à tension VEE. La saturation de ce transistor est ainsi évitée. Une résistance 75, représentée à la figure 3 en série avec la grille du transistor d'entrée du miroir de courant 65, constitue un moyen, connu en soi, pour accélérer la commutation de ce miroir.

Un tel circuit de retardement est simple et compact. Il permet un réglage précis de la remise à zéro des sources de courant du circuit pompe de charge, ce qui assure de ce fait un fonctionnement optimal de l'oscillateur verrouillé en phase.

## Revendications

1. Dispositif oscillateur verrouillé en phase dans lequel un oscillateur à fréquence variable délivre un signal de sortie contrôlé par une tension de commande issue d'une capacité réservoir chargée par un circuit pompe de charge, dispositif comportant un détecteur de phase dont une entrée reçoit un signal dérivé du signal de sortie de l'oscillateur à fréquence variable, une autre entrée reçoit un signal d'un oscillateur de référence, ledit détecteur étant également muni d'une entrée de remise à zéro, le circuit pompe de charge muni de deux sources de courant chacune composée de plusieurs transistors fonctionnant en parallèle, respectivement chargeant et déchargeant la capacité réservoir, et muni de deux entrées, d'une part, une première entrée de commande couplée à une première sortie du détecteur de phase laquelle fournit un signal de commutation dit signal de commande de montée, activant l'une des sources de courant, et d'autre part, une deuxième entrée de commande couplée à une deuxième sortie du détecteur de phase laquelle fournit un autre signal de commutation dit signal de commande de descente activant l'autre source de courant, dispositif dans lequel l'intervalle de temps durant lequel ces deux signaux de commande sont actifs simultanément est indiqué par un signal de remise à zéro, et dans lequel ledit signal de remise à zéro est issu d'une porte logique combinant les signaux de commande de montée et de descente et est appliqué à l'entrée de remise à zéro du détecteur de phase après passage dans un dispositif de retardement caractérisé en ce que le dispositif de retardement comprend d'une part une source de courant dite annexe, qui est commutable et formée par un transistor appairé à un transistor de l'une des sources de courant du circuit pompe de charge, et d'autre part, des moyens de comparaison du courant débité par cette source de courant annexe avec un seuil de courant déterminé qui délivrent le signal de remise à zéro lorsque ce seuil est atteint.

2. Dispositif selon la revendication 1, caractérisé en ce que les moyens dits de comparaison comprennent un miroir de courant dont une branche d'entrée reçoit le courant de la source de courant annexe et dont une branche de sortie constituant la sortie du dispositif de retardement est connectée en série à une sortie d'un générateur de courant de référence délivrant ledit seuil de courant.

3. Dispositif selon la revendication 2, caractérisé en ce que le miroir de courant et le générateur de courant de référence sont réalisés avec des transistors à effet de champs de type MOS.

4. Dispositif selon l'une quelconque des revendications 1 à 3, caractérisé en ce que les transistors formant les sources de courant du circuit pompe de charge ainsi que le transistor constituant la source de courant annexe sont des transistors bipolaires de type PNP.

**Patentansprüche**

1. Ein Phasenregelkreis, in dem ein Oszillator mit variabler Frequenz ein Ausgangssignal abgibt, das von einer Steuerspannung geregelt wird, die von einer Speicherkapazität kommt, die von einem Ladepumpenkreis geladen wird, ein Phasenregelkreis, der einen Phasendetektor umfaßt, der an einem Eingang ein Signal empfängt, das von Ausgangssignal des Oszillators mit variabler Frequenz abgeleitet ist, und an einem anderen Eingang ein Signal eines Bezugsoszillators empfängt, wobei der genannte Phasendetektor auch mit einem Nullstelleingang versehen ist, der Ladepumpenkreis mit zwei Stromquellen versehen ist, die jeweils aus mehreren, parallel arbeitenden Transistoren bestehen und die Speicherkapazität laden bzw. entladen, und mit zwei Eingängen versehen, einerseits mit einem ersten Steuereingang, der an einen ersten Ausgang des Phasendetektors gekoppelt ist, der ein Aufwärtssteuersignal genanntes Schaltsignal liefert, das eine der Stromquellen 1 aktiviert, und andererseits mit einem zweiten Steuereingang, der an einen zweiten Ausgang des Phasendetektors gekoppelt ist, der ein anderes, Abwärtssteuersignal genanntes Schaltsignal liefert, das die andere Stromquelle aktiviert, eine Vorrichtung, in der der Zeitraum, in dem diese beiden Steuersignale gleichzeitig aktiv sind, von einem Nullstellsignal angezeigt wird, und in dem das genannte Nullstellsignal von einem logischen Gatter abgegeben wird, das das Aufwärtssteuersignal und das Abwärtssteuersignal kombiniert, und in den Nullstelleingang des Phasendetektors eingespeist wird, nachdem es durch eine Verzögerungsvorrichung geleitet wurde, dadurch charakterisiert, daß die Verzögerungsvorrichtung einerseits eine Nebenstromquelle genannte Stromquelle umfaßt, die schaltbar ist und von einem Transistor gebildet wird, der schaltbar ist und mit einem der Transistoren einer der Stromquellen des Ladepumpenkreises gepaart ist, und andererseits Mittel zum Vergleichen des von dieser Nebenstromquelle abgegebenen Stroms mit einem bestimmten Schwellenstrom, die das Nullstellsignal liefern, wenn diese Schwelle erreicht ist.

2. Eine Vorrichtung nach Patentanspruch 1, dadurch gekennzeichnet, daß die genannten Vergleichsmittel einen Stromspiegel umfassen, desen einer Eingangszweig den Strom einer Nebenstromquelle empfängt, und dessen einer Ausgangszweig, der den Ausgang der Verzögerungsvorrichtung bildet, in Serie mit einem Ausgang eines Bezugsstromgenerators verbunden ist, der den genannten Schwellenstrom liefert.

3. Eine Vorrichtung nach Patentanspruch 2, dadurch gekennzeichnet, daß der Stromspiegel und der Bezugsstromgenerator mit Feldeffekttransistoren des Typs MOS hergestellt werden.

4. Eine Vorrichtung nach einem beliebigen der Patentansprüche 1 bis 3, dadurch gekennzeichnet, daß die Transistoren, die die Stromquellen des Ladepumpenkreises bilden, ebenso wie der Transistor, der die Nebenstromquelle bildet, bipolare Transistoren des Typs PNP sind.

## Claims

1. A phase-locked oscillator arrangement in which a variable-frequency oscillator supplies an output signal controlled by a control voltage from a storage capacitance, which is charged by a charge pump circuit, which arrangement comprises a phase detector having an input which receives a signal derived from the output signal of the variable-frequency oscillator and having another input which receives a signal from a reference oscillator, which detector also has a reset input, the charge pump circuit comprising two current sources which each comprise a plurality of transistors operating in parallel and which, respectively, charge and discharge the storage capacitance, which charge pump circuit has two inputs, *i.e.* a first control input coupled to a first output of the phase detector, which supplies a switching signal called the up-command signal, which activates one of the current sources, and a second control input coupled to a second output of the phase detector, which supplies a switching signal called the down-command signal, which activates the other current source, in which arrangement the time interval during which these two command signals are simultaneously active is indicated by a reset signal and in which said reset signal is obtained from a logic gate which combines the up-command signal and the down-command signal, which reset signal is applied to the reset input of the phase detector after passage through a delay device, characterized in that the delay device comprises a current source called annexed current source, which is switchable and comprises a transistor forming a matched pair with a transistor of one of the current sources of the charge pump circuit, and comparison means for comparing the current supplied by said annexed current source with a given threshold current, which means supply the reset signal when this threshold is reached.

2. An arrangement as claimed in Claim 1, characterized in that said comparison means comprise a current mirror having an input branch receiving the current from the annexed current source and having an output branch, which forms the output of the delay device, connected in series with an output of a reference current generator which supplies said current threshold.

3. An arrangement as claimed in Claim 2, characterized in that the current mirror and the reference current generator are constructed by means of MOS-type field effect transistors.

4. An arrangement as claimed in any one of the Claims 1 to 3, characterized in that the transistors forming the current sources of the charge pump circuit and the transistor forming the annexed current source are PNP-type bipolar transistors.

FIG.1

FIG.3

FIG.2